# EUROPEAN PATENT APPLICATION

(11) **EP 4 792 927 A1**
(43) Date of publication of application: **19.08.2026**
(21) Application number: 24877220.4
(22) Date of filing: 09.10.2024
(51) Int. Cl.: B01J 19/00, B01D 3/14, B81B 1/00

(54) **MICRO GAS-LIQUID COUNTERFLOW CONTACT DEVICE**

(30) Priority: 13.10.2023 JP 2023177902
(71) Applicant: IMT Taiwan Co., Ltd., Hsinchu City, 30013 (TW); Institute Of Microchemical Technology Co., Ltd., Kawasaki-shi, Kanagawa 212-0032 (JP)
(72) Inventor: MORIKAWA, Kyojiro, Hsinchu City 30013 (TW); KITAMORI, Takehiko, Hsinchu City 30013 (TW); CHEN, Chih-Chen, Hsinchu City 30013 (TW)
(74) Representative: Hoffmann Eitle
(86) International application number: PCT/JP2024/036208
(87) International publication number: WO 2025/079626

(57) **Abstract**

A micro gas-liquid counterflow contact device includes: a gas-liquid counterflow contact unit including a liquid introduction port through which a mixed liquid containing at least two types of components different in boiling point is introduced, a vapor introduction port through which a mixed-liquid-derived vapor is introduced, a gas-liquid contact flow path configured to bring the mixed liquid introduced from the liquid introduction port and the mixed-liquid-derived vapor introduced from the vapor introduction port into contact with each other in counterflows, a liquid discharge port from which the mixed liquid flowing through the gas-liquid contact flow path is discharged, and a vapor discharge port from which the mixed-liquid-derived vapor flowing through the gas-liquid contact flow path is discharged; a first circulation unit configured to circulate, to the liquid introduction port, a condensate obtained by condensing the mixed-liquid-derived vapor discharged from the vapor discharge port; and a second circulation unit configured to circulate, to the vapor introduction port, the vapor obtained by evaporating the mixed liquid discharged from the liquid discharge port.

## Description

### Technical Field

The present disclosure relates to a micro gas-liquid counterflow contact device.

### Background Art

There has been known a technique for performing predetermined unit operation by bringing gas and liquid into gas-liquid contact with each other (for example, see Patent document 1). On a gas-liquid interface where the gas and the liquid are brought into gas-liquid contact with each other, for example, substance transfer is performed between the gas and the liquid.

### Citation List

### Patent document

Patent document 1: Japanese Patent Laid-Open No. 2006-198542
Patent document 2: Japanese Patent Laid-Open No. 2007-136280
Patent document 3: Japanese Patent No. 5627837

### Summary of the Invention

### Problems to be solved by the invention

An existing gas-liquid contact device has room for improvement in terms of efficiency when the gas and the liquid are brought into gas-liquid contact with each other. The technique of the present disclosure is made in consideration of such circumstances, and an object thereof is to provide a gas-liquid contact device that can efficiently bring the gas and the liquid into gas-liquid contact with each other.

### Means for solving the Problems

The following is a summary of the present disclosure.

### [Aspect 1]

A micro gas-liquid counterflow contact device according to Aspect 1, includes:
a gas-liquid counterflow contact unit including a liquid introduction port through which a mixed liquid containing at least two types of components different in boiling point is introduced, a vapor introduction port through which a mixed-liquid-derived vapor is introduced, a gas-liquid contact flow path configured to bring the mixed liquid introduced from the liquid introduction port and the mixed-liquid-derived vapor introduced from the vapor introduction port into contact with each other in counterflows, a liquid discharge port from which the mixed liquid flowing through the gas-liquid contact flow path is discharged, and a vapor discharge port from which the mixed-liquid-derived vapor flowing through the gas-liquid contact flow path is discharged;
a first circulation unit configured to circulate, to the liquid introduction port, a condensate obtained by condensing the mixed-liquid-derived vapor discharged from the vapor discharge port; and
a second circulation unit configured to circulate, to the vapor introduction port, the vapor obtained by evaporating the mixed liquid discharged from the liquid discharge port.

### [Aspect 2]

The micro gas-liquid counterflow contact device according to Aspect 1, in which
in the gas-liquid counterflow contact unit, the gas-liquid contact flow path is configured as a flow path extending in one direction,
one end side of the gas-liquid contact flow path is disposed on an upper side in a vertical direction, and the liquid introduction port and the vapor discharge port are disposed on the one end side, and
another end side of the gas-liquid contact flow path is disposed on a lower side in the vertical direction, and the liquid discharge port and the vapor introduction port are disposed on the other end side.

### [Aspect 3]

The micro gas-liquid counterflow contact device according to Aspect 1 or 2, in which, in the gas-liquid counterflow contact unit, the mixed liquid introduced from the liquid introduction port flows down in a liquid flowing region formed along a flow path wall surface forming the gas-liquid contact flow path, and the mixed-liquid-derived vapor supplied from the vapor introduction port flows in a direction opposite to the direction of the mixed liquid, along a vapor flowing region formed on a cross-section center side of the gas-liquid contact flow path.

### [Aspect 4]

The micro gas-liquid counterflow contact device according to any one of Aspects 1 to 3, in which the gas-liquid counterflow contact unit includes a plurality of the liquid introduction ports and a plurality of the liquid discharge ports.

### [Aspect 5]

The micro gas-liquid counterflow contact device according to Aspect 4, in which
the flow path wall surface of the gas-liquid counterflow contact unit includes a first surface and a second surface different from the first surface,
the plurality of liquid introduction ports include first and second liquid introduction ports disposed on one end side of the gas-liquid contact flow path,
the plurality of liquid discharge ports include first and second liquid discharge ports disposed on another end side of the gas-liquid contact flow path,
the mixed liquid introduced from the first liquid introduction port flows down on the first surface of the flow path wall surface, and then, is discharged from the first liquid discharge port, and
the mixed liquid introduced from the second liquid introduction port flows down on the second surface of the flow path wall surface, and then, is discharged from the second liquid discharge port.

### [Aspect 6]

The micro gas-liquid counterflow contact device according to Aspect 2, in which the gas-liquid counterflow contact unit further includes an intermediate introduction port introducing the mixed liquid at an intermediate position of the gas-liquid contact flow path, separately from the liquid introduction port disposed on the one end side of the gas-liquid contact flow path.

### [Aspect 7]

The micro gas-liquid counterflow contact device according to any one of Aspects 1 to 6, in which the first circulation unit includes a first storage tank configured to store the condensate obtained by condensing the mixed-liquid-derived vapor discharged from the vapor discharge port.

### [Aspect 8]

The micro gas-liquid counterflow contact device according to any one of Aspects 1 to 7, in which the second circulation unit includes a second storage tank configured to store the mixed liquid discharged from the liquid discharge port of the gas-liquid counterflow contact unit.

### [Aspect 9]

The micro gas-liquid counterflow contact device according to any one of Aspects 1 to 8, in which the second circulation unit further includes an evaporation unit including a micro flow path through which the mixed liquid discharged from the liquid discharge port of the gas-liquid counterflow contact unit flows, and an evaporation heater configured to evaporate the mixed liquid flowing through the micro flow path.

### [Aspect 10]

The micro gas-liquid counterflow contact device according to any one of Aspects 1 to 9, in which the gas-liquid counterflow contact unit further includes a temperature adjustment mechanism configured to form a predetermined temperature gradient in which the temperature is gradually reduced from one end side toward another end side of the gas-liquid contact flow path.

### [Aspect 11]

The micro gas-liquid counterflow contact device according to Aspect 2, in which, in the gas-liquid counterflow contact unit, a liquid introduction path connecting the one end side of the gas-liquid contact flow path and the liquid introduction port, and a liquid discharge path connecting the other end side of the gas-liquid contact flow path and the liquid discharge port are formed as micro flow paths.

### [Aspect 12]

The micro gas-liquid counterflow contact device according to Aspect 3, in which a liquid film thickness of the mixed liquid flowing down along the flow path wall surface is in the order of micrometers.

### Effects of the invention

The technique according to the present disclosure can provide a gas-liquid contact device that can efficiently bring the gas and the liquid into gas-liquid contact with each other.

### Brief Description of the Drawings

[Fig. 1] Fig. 1 is an outline configuration diagram illustrating an example of a micro gas-liquid counterflow contact device according to Embodiment 1.
[Fig. 2] Fig. 2 is a plan view of a gas-liquid counterflow contact unit according to Embodiment 1.
[Fig. 3] Fig. 3 is a diagram for explaining a method of fabricating the gas-liquid counterflow contact unit according to Embodiment 1.
[Fig. 4] Fig. 4 is a diagram schematically illustrating a cross-section taken along line A-A illustrated in Fig. 2.
[Fig. 5] Fig. 5 is a diagram for explaining a temperature adjustment mechanism.
[Fig. 6] Fig. 6 is a diagram for explaining temperature measurement points in Examples.
[Fig. 7] Fig. 7 is a diagram for explaining an experimental apparatus used in Comparative Examples.
[Fig. 8] Fig. 8 is a diagram for explaining a micro gas-liquid counterflow contact device according to Embodiment 2.

### Mode for Carrying Out the Invention

A micro gas-liquid counterflow contact device according to each of embodiments of the present disclosure is described below with reference to drawings. Components, combinations thereof, and the like according to the embodiments are illustrative, and addition, omission, substitution, and other changes of components can be made as appropriate within a scope not departing from the spirit of the present disclosure. The present disclosure is not limited by the embodiments, and is limited only by the claims. Further, aspects disclosed in the present specification can be combined with any other features disclosed in the present specification.

### <Embodiment 1>

### <<Micro Gas-Liquid Counterflow Contact Device>>

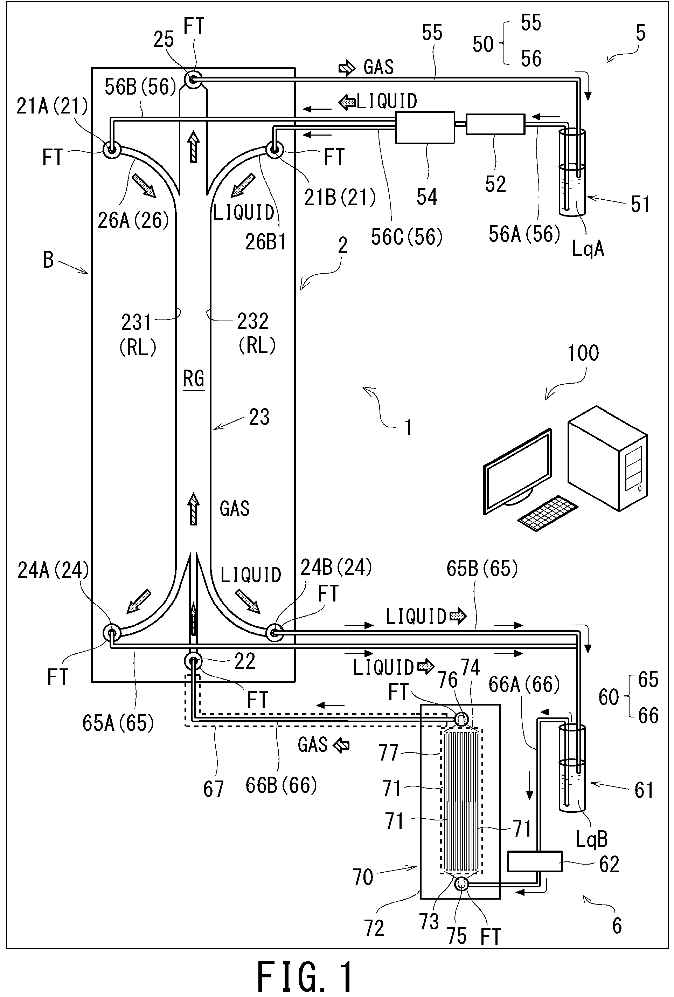

Fig. 1 is an outline configuration diagram illustrating an example of a micro gas-liquid counterflow contact device 1 according to Embodiment 1.

The micro gas-liquid counterflow contact device 1 is a microfluidic device that includes a gas-liquid counterflow contact unit 2, a first circulation unit 5, a second circulation unit 6, and the like, and performs predetermined unit operation (chemical/physical operation) on a mixed fluid containing at least two types of components different in boiling point. In the present specification, "fluid" may include, in addition to liquid and gas, a mixture of liquid and gas, and a mixed-phase fluid in which solid is mixed in liquid and/or gas.

### [Gas-Liquid Counterflow Contact Unit]

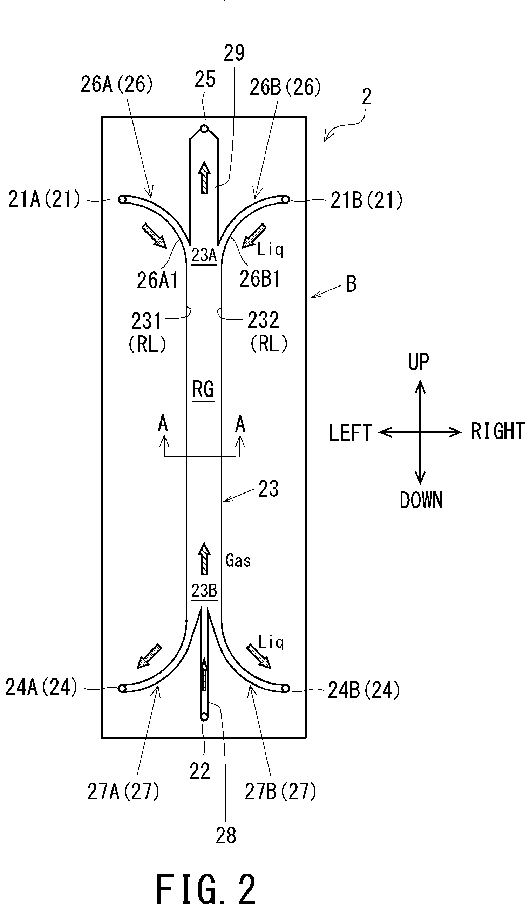

Fig. 2 is a plan view of the gas-liquid counterflow contact unit 2 according to Embodiment 1. A reference symbol B in the drawing denotes a substrate of the gas-liquid counterflow contact unit 2. The substrate B has a chip form in a rectangular plate shape. Although details are described below, the gas-liquid counterflow contact unit 2 is configured to receive a mixed liquid containing at least two types of components different in boiling point (hereinafter, simply referred to as "mixed liquid") from the first circulation unit 5, and to receive vapor obtained by evaporating the mixed liquid from the second circulation unit 6. Up, down, left, and right directions illustrated in Fig. 2 are used for convenience in order to explain relative positional relationship of elements with the substrate B of the gas-liquid counterflow contact unit 2 as a reference, and do not indicate absolute directions of the elements.

The gas-liquid counterflow contact unit 2 according to the present embodiment includes:
liquid introduction ports 21 through which the mixed liquid supplied from the first circulation unit 5 is introduced;
a vapor introduction port 22 through which the mixed-liquid-derived vapor supplied from the second circulation unit 6 is introduced;
a gas-liquid contact flow path 23 configured to bring the mixed liquid introduced from the liquid introduction ports 21 and the mixed-liquid-derived vapor introduced from the vapor introduction port 22 into contact with each other in counterflows;
liquid discharge ports 24 from which the mixed liquid flowing through the gas-liquid contact flow path 23 is discharged;
a vapor discharge port 25 from which the mixed-liquid-derived vapor flowing through the gas-liquid contact flow path 23 is discharged;
and the like.

The liquid introduction ports 21, the vapor introduction port 22, the gas-liquid contact flow path 23, the liquid discharge ports 24, the vapor discharge port 25, and the like are formed in the substrate B.

Although a form of the gas-liquid contact flow path 23 is not particularly limited, the gas-liquid contact flow path 23 is configured as a flow path (linearly) extending in one direction in the example illustrated in Fig. 1 and Fig. 2. Out of ends in an extending direction (axial direction) of the gas-liquid contact flow path 23, one end denoted by a reference numeral 23A is referred to as a "first end", and the other end denoted by a reference numeral 23B is referred to as a "second end". In the present embodiment, the liquid introduction ports 21 and the vapor discharge port 25 are disposed on the first end 23A side of the gas-liquid contact flow path 23, and the liquid discharge ports 24 and the vapor introduction port 22 are disposed on the second end 23B side. However, arrangement of these ports is illustrative. A length (length from first end 23A to second end 23B) of the gas-liquid contact flow path 23 in the extending direction (axial direction) can be 10 mm or more and 3000 mm or less, is preferably 20 mm or more and 2000 mm or less, and is more preferably 30 mm or more and 1000 mm or less.

The gas-liquid counterflow contact unit 2 further includes liquid introduction paths 26 connecting the first end 23A (one end) side of the gas-liquid contact flow path 23 and the liquid introduction ports 21, and liquid discharge paths 27 connecting the second end 23B (other end) side of the gas-liquid contact flow path 23 and the liquid discharge ports 24. The mixed liquid supplied from the first circulation unit 5 to the liquid introduction ports 21 of the gas-liquid counterflow contact unit 2 is guided to the first end 23A of the gas-liquid contact flow path 23 through the liquid introduction paths 26. The mixed liquid guided to the first end 23A of the gas-liquid contact flow path 23 flows through the gas-liquid contact flow path 23 along the gas-liquid contact flow path 23 that linearly extends (namely, from first end 23A side toward second end 23B side). The mixed liquid having flowed through the gas-liquid contact flow path 23 flows through the liquid discharge paths 27 connected to the second end 23B side of the gas-liquid contact flow path 23, and then is discharged from the liquid discharge ports 24 to the outside of the gas-liquid counterflow contact unit 2.

In the example illustrated in Fig. 1 and Fig. 2, the gas-liquid counterflow contact unit 2 includes two liquid introduction ports 21. In a case where the liquid introduction ports 21 are distinguished from each other, the liquid introduction ports 21 are referred to as a first liquid introduction port 21A and a second liquid introduction port 21B. Further, the gas-liquid counterflow contact unit 2 includes two liquid discharge ports 24. In a case where the liquid discharge ports 24 are distinguished from each other, the liquid discharge ports 24 are referred to as a first liquid discharge port 24A and a second liquid discharge port 24B. However, in the gas-liquid counterflow contact unit 2, the number of liquid introduction ports 21 and the number of liquid discharge ports 24 are not particularly limited.

Further, as illustrated in Fig. 1 and Fig. 2, the gas-liquid counterflow contact unit 2 includes two liquid introduction paths 26 corresponding to the respective liquid introduction ports 21A and 21B, and two liquid discharge paths 27 corresponding to the respective liquid discharge ports 24A and 24B. A first liquid introduction path 26A connects the first liquid introduction port 21A and the first end 23A side of the gas-liquid contact flow path 23. A second liquid introduction path 26B connects the second liquid introduction port 21B and the first end 23A side of the gas-liquid contact flow path 23. A first liquid discharge path 27A connects the second end 23B side of the gas-liquid contact flow path 23 and the first liquid discharge port 24A. A second liquid discharge path 27B connects the second end 23B side of the gas-liquid contact flow path 23 and the second liquid discharge port 24B. As illustrated in Fig. 2, in a plan view of the gas-liquid counterflow contact unit 2, each of the liquid introduction paths 26 and the liquid discharge paths 27 has a curved shape. However, the shape of each of the liquid introduction paths 26 and the liquid discharge paths 27 is not particularly limited.

The gas-liquid counterflow contact unit 2 further includes a vapor introduction path 28 connecting the second end 23B side of the gas-liquid contact flow path 23 and the vapor introduction port 22, and a vapor discharge path 29 connecting the first end 23A side of the gas-liquid contact flow path 23 and the vapor discharge port 25. The mixed-liquid-derived vapor supplied from the second circulation unit 6 to the vapor introduction path 28 of the gas-liquid counterflow contact unit 2 is guided to the second end 23B of the gas-liquid contact flow path 23 through the vapor introduction path 28. The mixed-liquid-derived vapor guided to the second end 23B of the gas-liquid contact flow path 23 flows through the gas-liquid contact flow path 23 along the gas-liquid contact flow path 23 that linearly extends (namely, from second end 23B side toward first end 23A side). In other words, a direction in which the mixed-liquid-derived vapor flows along the gas-liquid contact flow path 23 is opposite to a direction of the mixed liquid flowing from the first end 23A side toward the second end 23B side. The mixed-liquid-derived vapor having flowed through the gas-liquid contact flow path 23 flows through the vapor discharge path 29 connected to the first end 23A side of the gas-liquid contact flow path 23, and then is discharged from the vapor discharge port 25 to the outside of the gas-liquid counterflow contact unit 2.

As an example, the gas-liquid counterflow contact unit 2 can be fabricated by forming the liquid introduction ports 21, the vapor introduction port 22, the gas-liquid contact flow path 23, the liquid discharge ports 24, the vapor discharge port 25, the liquid introduction paths 26, the liquid discharge paths 27, the vapor introduction path 28, the vapor discharge path 29, and the like in the substrate B.

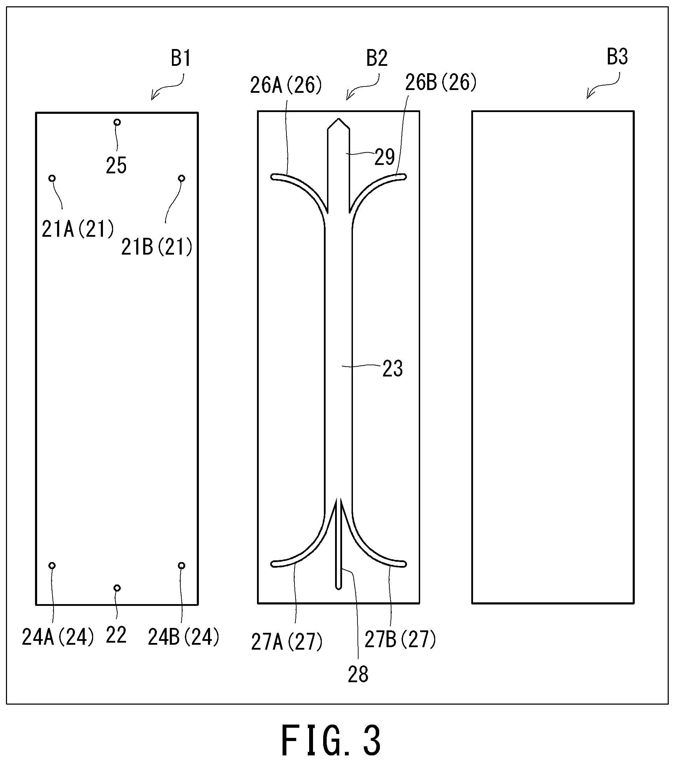

Fig. 3 is a diagram for explaining a method of fabricating the gas-liquid counterflow contact unit 2 according to Embodiment 1. A first substrate B1 illustrated in Fig. 3 is, for example, a substrate forming a front surface side of the gas-liquid counterflow contact unit 2. A third substrate B3 is, for example, a substrate forming a rear surface side of the gas-liquid counterflow contact unit 2. A second substrate B2 is, for example, a substrate forming an intermediate layer sandwiched between the first substrate B1 and the third substrate B3. Each of the substrates B1 to B3 is a plate-shaped member having a rectangular shape in a plan view, and has, for example, a congruent plan form. However, a shape, a size, and the like of each of the substrates B1 to B3 are not particularly limited. Further, a material of each of the substrates B1 to B3 is not particularly limited, and for example, glass, silicon, silica, quartz, a resin, and silicon carbide can be used. Further, as a material of the substrates B1 and B2, borosilicate glass that has chemical resistance to organic chemical substances and heat resistance is preferably used.

As the method of fabricating the gas-liquid counterflow contact unit 2, for example, openings for forming the liquid introduction ports 21, the vapor introduction port 22, the liquid discharge ports 24, the vapor discharge port 25, and the like are formed as through holes penetrating through the first substrate B1 in a thickness direction, in the first substrate B1. Further, openings for forming flow paths such as the gas-liquid contact flow path 23, the liquid introduction paths 26, the liquid discharge paths 27, the vapor introduction path 28, and the vapor discharge path 29 are formed as through holes penetrating through the second substrate B2, in the second substrate B2. The first substrate B1 may be bonded to one of surfaces of the second substrate B2 and the third substrate B3 may be bonded to the other surface of the second substrate B2. As a result, the above-described various kinds of flow paths through which the mixed liquid and the mixed-liquid-derived vapor flow can be formed inside a substrate assembly. The substrates forming the gas-liquid counterflow contact unit 2 may be transparent or translucent substrates. This enables visual recognition of the flow paths such as the gas-liquid contact flow path 23, the liquid introduction paths 26, the liquid discharge paths 27, the vapor introduction path 28, and the vapor discharge path 29 from the outside.

Although a method of forming the through holes in the first substrate B1 and the second substrate B2 is not particularly limited, for example, the through holes may be formed by performing etching, micromachining, and the like on the first substrate B1 and the second substrate B2. As a matter of course, the method of fabricating the above-described gas-liquid counterflow contact unit 2 is illustrative, and the fabrication method can employ various aspects and is not particularly limited. For example, the gas-liquid counterflow contact unit 2 may be fabricated by stacking two substrates, or the gas-liquid counterflow contact unit 2 may be fabricated by stacking four or more substrates. Note that a one-touch joint such as a tube fitting can be attached to each of the openings for forming the liquid introduction ports 21, the vapor introduction port 22, the liquid discharge ports 24, the vapor discharge port 25, and the like.

The gas-liquid counterflow contact unit 2 configured as described above is formed as, for example, a microfluidic device in a chip form including microscale flow paths. In use, the gas-liquid counterflow contact unit 2 is disposed such that the first end 23A side of the gas-liquid contact flow path 23 is positioned on an upper side (directed upward) in a vertical direction, and the second end 23B side is positioned on a lower side (directed downward) in the vertical direction. In the following, the extending direction of the gas-liquid contact flow path 23 in the gas-liquid counterflow contact unit 2 is referred to as an "up-down direction", and a left-right direction is referred to as a "width direction".

In the gas-liquid counterflow contact unit 2, the liquid introduction paths 26 and the liquid discharge paths 27 described above are formed as micro flow paths. In the present specification, at least one of the flow path width and the flow path height of each of the liquid introduction paths 26 and the liquid discharge paths 27 formed as the micro flow paths is in the order of micrometers (µm). For example, the flow path width of each of the liquid introduction paths 26 and the liquid discharge paths 27 can be 100 µm or more and 800 µm or less, is preferably 150 µm or more and 600 µm or less, and is more preferably 200 µm or more and 500 µm or less. The flow path height of each of the liquid introduction paths 26 and the liquid discharge paths 27 can be 100 µm or more and 5000 µm or less, is preferably 150 µm or more and 4000 µm or less, and is more preferably 200 µm or more and 3000 µm or less.

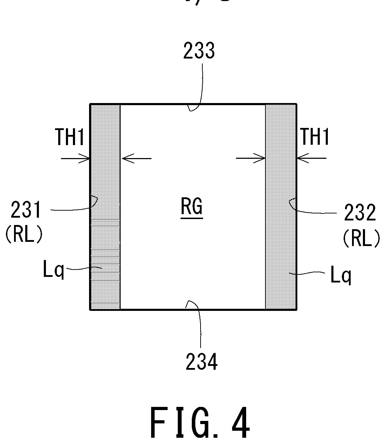

Fig. 4 is a diagram schematically illustrating a cross-section taken along line A-A illustrated in Fig. 2. In other words, Fig. 4 illustrates a cross-section of the gas-liquid contact flow path 23 of the gas-liquid counterflow contact unit 2. The cross-section of the gas-liquid contact flow path 23 is a cross-section in a direction orthogonal to the axial direction in which the gas-liquid contact flow path 23 extends. Although the cross-sectional shape of the gas-liquid contact flow path 23 illustrated in Fig. 4 is illustrative, in the example illustrated in Fig. 4, the gas-liquid contact flow path 23 has a square-shaped cross-section.

Reference numerals 231 to 234 illustrated in Fig. 4 denote first to fourth flow path wall surfaces forming the gas-liquid contact flow path 23. The gas-liquid counterflow contact unit 2 according to the present embodiment is configured such that a liquid flowing region is formed in a whole or a part of each of the flow path wall surfaces 231 to 234, and the mixed liquid flows down along the liquid flowing regions. In the example illustrated in Fig. 4, the first flow path wall surface 231 and the second flow path wall surface 232 are disposed to face each other, and extend, for example, along side surfaces of the gas-liquid counterflow contact unit 2. Likewise, the third flow path wall surface 233 and the fourth flow path wall surface 234 are disposed to face each other, and extend, for example, along a front surface of the gas-liquid counterflow contact unit 2.

For example, the first flow path wall surface 231 of the gas-liquid contact flow path 23 is connected flush with a flow path wall surface 26A1 (see Fig. 2) of the first liquid introduction path 26A. The term "flush" used herein indicates an aspect in which the wall surfaces are connected without forming a level difference at a connected portion. Further, the second flow path wall surface 232 of the gas-liquid contact flow path 23 is connected flush with a flow path wall surface 26B1 (see Fig. 2) of the second liquid introduction path 26B. In such an aspect, when the mixed liquid introduced from the first liquid introduction port 21A of the gas-liquid counterflow contact unit 2 flows into the gas-liquid contact flow path 23 through the first liquid introduction path 26A, the mixed liquid easily flows down along the first flow path wall surface 231 (first surface) connected flush with the flow path wall surface 26A1 of the first liquid introduction path 26A. In the above-described manner, after the mixed liquid flows downward along the first flow path wall surface 231, the mixed liquid is discharged from the first liquid discharge port 24A through the first liquid discharge path 27A. Likewise, when the mixed liquid introduced from the second liquid introduction port 21B of the gas-liquid counterflow contact unit 2 flows into the gas-liquid contact flow path 23 through the second liquid introduction path 26B, the mixed liquid easily flows down along the second flow path wall surface 232 (second surface different from first surface) connected flush with the flow path wall surface 26B1 of the second liquid introduction path 26B. In the above-described manner, after the mixed liquid flows downward along the second flow path wall surface 232, the mixed liquid is discharged from the second liquid discharge port 24B through the second liquid discharge path 27B. As described above, the mixed liquid is introduced to the two different flow path wall surfaces 231 and 232 of the gas-liquid contact flow path 23 of the gas-liquid counterflow contact unit 2 through two systems, and the mixed liquid flowing down on the flow path wall surfaces 231 and 232 is discharged through two systems, which makes it possible to cause the mixed liquid to smoothly flow along the flow path wall surfaces 231 and 232. In addition, a flow rate of the mixed liquid can be easily secured while the gas-liquid contact flow path 23 is prevented from being blocked by the mixed liquid.

As described above, in the gas-liquid contact flow path 23 of the gas-liquid counterflow contact unit 2, all or a part of the flow path wall surfaces 231 to 234 (for example, first flow path wall surface 231 and second flow path wall surface 232) extending in the vertical direction can be caused to function as wet walls on which the mixed liquid flows down in a thin-film form. This makes it possible to cause the mixed liquid to flow down along the flow path wall surfaces forming the gas-liquid contact flow path 23 while forming a hollow vapor flowing region through which the mixed-liquid-derived vapor flows, on the cross-section center side of the gas-liquid contact flow path 23.

The illustrative aspect illustrated in Fig. 4 illustrates a state where the mixed liquid (reference symbol Lq in Fig. 4) flows down along liquid flowing regions RL formed on the first flow path wall surface 231 and the second flow path wall surface 232. In a hollow vapor flowing region RG formed on the cross-section center side of the gas-liquid contact flow path 23, the mixed-liquid-derived vapor flows in a direction opposite to the direction of the mixed liquid along the vapor flowing region RG. This makes it possible to prevent the gas-liquid contact flow path 23 from being blocked by the mixed liquid. As a result, the mixed liquid introduced from the liquid introduction ports 21 and the mixed-liquid-derived vapor introduced from the vapor introduction port 22 can be brought into gas-liquid contact with each other in the gas-liquid contact flow path 23 in counterflows. As a result, the mixed-liquid-derived vapor and the mixed liquid can efficiently perform heat exchange and substance exchange. In particular, the gas-liquid counterflow contact unit 2 according to the present embodiment can cause the mixed liquid to suitably flow down along the flow path wall surfaces of the gas-liquid contact flow path 23 by using gravity. In other words, the flow path wall surfaces of the gas-liquid contact flow path 23 extending in the vertical direction can be caused to function as wet walls, and the mixed liquid can be caused to suitably flow down along the flow path wall surfaces. Note that, to cause the mixed liquid to suitably flow down on the flow path wall surfaces (liquid flowing regions RL) of the gas-liquid contact flow path 23, the action of gravity and wettability of a base material (wall surface material) forming the flow path wall surfaces may be involved. Therefore, each of the flow path wall surfaces is preferably designed as a wet wall in which a contact angle (θ) of the flow path wall surface (base material) of the gas-liquid contact flow path 23 and the mixed liquid (liquid) is less than 90 degrees.

In the present embodiment, a liquid film thickness of the mixed liquid flowing down along the liquid flowing regions RL of the gas-liquid contact flow path 23 can be in the order (scale) of micrometers. For example, the liquid film thickness can be 10 µm or more and 1000 µm or less, is preferably 50 µm or more and 800 µm or less, and is more preferably 100 µm or more and 600 µm or less. This makes it possible to suitably prevent the cross-section of the gas-liquid contact flow path 23 from being blocked by the mixed liquid flowing down along the liquid flowing regions RL of the gas-liquid contact flow path 23. Further, by causing the mixed liquid to flow down along the plurality of different flow path wall surfaces 231 and 232 forming the gas-liquid contact flow path 23 as described above, it is possible to suitably prevent the cross-section of the gas-liquid contact flow path 23 from being blocked by the mixed liquid while securing a total flow rate of the mixed liquid flowing down along the liquid flowing regions RL. From the above-described viewpoint, although not particularly limited, the shape of the flow-path cross-section of the gas-liquid contact flow path 23 can be, for example, a square shape. In this case, a length (corresponding to flow path width) of each side of the square can be 0.1 mm or more and 5 mm or less, is preferably 0.2 mm or more and 4 mm or less, and is more preferably 0.5 mm or more and 3 mm or less. This makes it possible to suitably prevent the cross-section of the gas-liquid contact flow path 23 from being blocked by the mixed liquid while securing the total flow rate of the mixed liquid flowing down along the liquid flowing regions RL.

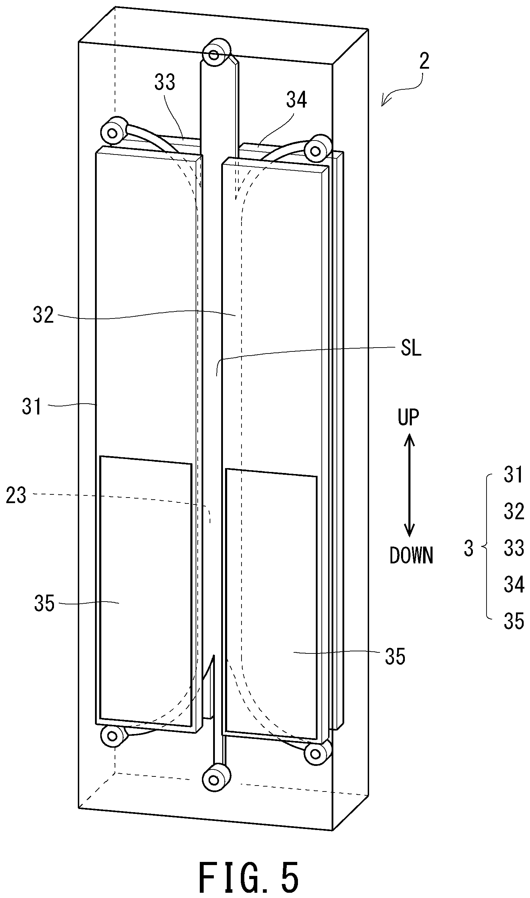

The gas-liquid counterflow contact unit 2 according to the present embodiment further includes a temperature adjustment mechanism 3 that forms a predetermined temperature gradient in which the temperature is gradually reduced from the second end 23B side to the first end 23A side of the gas-liquid contact flow path 23. Fig. 5 is a diagram for explaining the temperature adjustment mechanism 3. The temperature adjustment mechanism 3 includes temperature adjustment heaters, and heat conductive members for conducting heat from the temperature adjustment heaters.

In the example illustrated in Fig. 5, a first heat conductive member 31 and a second heat conductive member 32 are attached on a front surface of the gas-liquid counterflow contact unit 2, and a third heat conductive member 33 and a fourth heat conductive member 34 are attached to a rear surface of the gas-liquid counterflow contact unit 2. Each of the heat conductive members 31 to 34 has a plate shape, and is made of, for example, a heat conductor such as a copper plate. In the example illustrated in Fig. 5, the heat conductive members 31 to 34 each have the same shape, but the shape is not limited thereto. As a matter of course, the heat conductive members 31 to 34 may be made of another metal excellent in heat conductivity.

On the front surface side of the gas-liquid counterflow contact unit 2, a clearance (slit for visual recognition) SL extending along the up-down direction is formed between the first heat conductive member 31 and the second heat conductive member 32, and the gas-liquid contact flow path 23 can be visually recognized through the clearance SL. The third heat conductive member 33 and the fourth heat conductive member 34 disposed on the rear surface side of the gas-liquid counterflow contact unit 2 are similarly arranged. In other words, a clearance (slit for visual recognition) SL extending along the up-down direction is formed between the third heat conductive member 33 and the fourth heat conductive member 34, and the gas-liquid contact flow path 23 can be visually recognized through the clearance SL.

For example, as illustrated in Fig. 5, each of the heat conductive members 31 to 34 extends in the up-down direction of the gas-liquid counterflow contact unit 2 so as to cover a height corresponding to the first end 23A of the gas-liquid flow path 23 to a height corresponding to the second end 23B of the gas-liquid contact flow path 23 in the up-down direction of the gas-liquid counterflow contact unit 2. A reference numeral 35 illustrated in Fig. 5 denotes the temperature adjustment heater. The temperature adjustment heaters 35 are, for example, film heaters, and are bonded to lower regions of the heat conductive members 31 to 34. Generated heat during operation of the temperature adjustment heaters 35 attached to the heat conductive members 31 to 34 is transmitted to the gas-liquid contact flow path 23 of the gas-liquid counterflow contact unit 2 through the heat conductive members 31 to 34. At this time, the heat of the temperature adjustment heaters 35 is easily transmitted as a distance from the temperature adjustment heaters 35 is small, and is difficult to be transmitted as the distance from the temperature adjustment heaters 35 is large. As a result, an appropriate temperature gradient (temperature distribution) occurs along the extending direction (long axis direction) of the gas-liquid contact flow path 23. More specifically, a predetermined temperature gradient (temperature distribution) in which the temperature is gradually reduced from the second end 23B side to the first end 23A side of the gas-liquid contact flow path 23 can be formed. Depending on boiling points of the components contained in the mixed liquid, the set temperature of the temperature adjustment heaters 35 can be 30°C or more and 400°C or less, is preferably 40°C or more and 350°C or less, and is more preferably 50°C or more and 300°C or less.

### [First Circulation Unit]

Next, the first circulation unit 5 of the micro gas-liquid counterflow contact device 1 is described with reference to Fig. 1. The first circulation unit 5 is a unit that circulates a condensate obtained by condensing the mixed-liquid-derived vapor discharged from the vapor discharge port 25 of the gas-liquid counterflow contact unit 2, to the liquid introduction ports 21 of the gas-liquid counterflow contact unit 2 again.

The first circulation unit 5 includes a first circulation conduit 50, a first storage tank 51, a first circulation pump 52, a distributor 54, and the like. The first circulation conduit 50 includes a return pipe 55 and a forward pipe 56. The return pipe 55 is a pipe that condenses the mixed-liquid-derived vapor discharged from the vapor discharge port 25 of the gas-liquid counterflow contact unit 2 in a transfer process, and transfers the condensate obtained as a result to the first storage tank 51. For example, one end side of the return pipe 55 is connected to the vapor discharge port 25 of the gas-liquid counterflow contact unit 2 through a joint FT, and the other end side thereof is connected to the first storage tank 51. The mixed-liquid-derived vapor discharged from the vapor discharge port 25 of the gas-liquid counterflow contact unit 2 is cooled and condensed in a process of flowing through the return pipe 55. The mixed liquid (condensate) phase-changed from the gas phase to the liquid phase in the process of flowing through the return pipe 55 is stored in the first storage tank 51. The joint FT is a one-touch joint such as a tube fitting, and air-tightly connects the vapor discharge port 25 of the gas-liquid counterflow contact unit 2 and the return pipe 55.

The forward pipe 56 is a pipe that transfers (supplies) the mixed liquid (condensate) stored in the first storage tank 51 to the liquid introduction ports 21 of the gas-liquid counterflow contact unit 2. The gas-liquid counterflow contact unit 2 according to the present embodiment includes the two liquid introduction ports 21 (first liquid introduction port 21A and second liquid introduction port 21B). Therefore, the distributor 54 is disposed in a middle of the forward pipe 56 to branch the forward pipe 56 to two branch pipes.

A section of the forward pipe 56 from the first storage tank 51 as a starting point to the distributor 54 is referred to as a main pipe 56A, and the two branch pipes branched from the main pipe 56A by the distributor 54 are referred to as a first branch pipe 56B and a second branch pipe 56C. One end side of the first branch pipe 56B is connected to the distributor 54, and the other end side thereof is connected to the first liquid introduction port 21A of the gas-liquid counterflow contact unit 2. One end side of the second branch pipe 56C is connected to the distributor 54, and the other end side thereof is connected to the second liquid introduction port 21B of the gas-liquid counterflow contact unit 2. As a material of the distributor 54, borosilicate glass that has chemical resistance to organic chemical substances and heat resistance may be used.

The first circulation pump 52 is connected to the main pipe 56A of the forward pipe 56. When the first circulation pump 52 operates, a mixed liquid (condensate) LqA stored in the first storage tank 51 is forcibly sent (for example, fed) to the forward pipe 56 (main pipe 56A), and the mixed liquid (condensate) LqA flows through the forward pipe 56 from an upstream to a downstream. In other words, the mixed liquid (condensate) LqA fed by the first circulation pump 52 is supplied to the gas-liquid counterflow contact unit 2 through the forward pipe 56. At this time, the mixed liquid (condensate) LqA is introduced to the first liquid introduction port 21A through the first branch pipe 56B of the forward pipe 56, and is introduced to the second liquid introduction port 21B through the second branch pipe 56C of the forward pipe 56. Although the type of the first circulation pump 52 is not particularly limited, for example, a syringe pump and a diaphragm pump are usable.

Each of the return pipe 55 and the forward pipe 56 of the first circulation conduit 50 may be, for example, a flexible tube having a small diameter. For example, a PEEK (Poly Ether Ether Ketone) tube using a PEEK resin that is a material having chemical resistance to organic chemical substances can be suitably used. An inner diameter of the first circulation conduit 50 (PEEK tube) may be in the order (scale) of micrometers, for example, can be 60 µm or more and 1000 µm or less, is preferably 80 µm or more and 700 µm or less, and is more preferably 100 µm or more and 500 µm or less. In particular, when the inner diameter of the return pipe 55 is in the order of micrometers as in the above-described aspect, it is possible to increase a heat transfer area for the vapor discharged from the vapor discharge port 25 of the gas-liquid counterflow contact unit 2. As a result, it is possible to condense the vapor discharged from the vapor discharge port 25 only by cooling action using the outside temperature without using a condenser or a specific refrigerant for condensing the vapor.

### [Second Circulation Unit]

Next, the second circulation unit 6 of the micro gas-liquid counterflow contact device 1 is described with reference to Fig. 1. The second circulation unit 6 is a unit that evaporates the mixed liquid discharged from the gas-liquid counterflow contact unit 2, and circulates the vapor of the mixed liquid to the vapor introduction port 22 of the gas-liquid counterflow contact unit 2 again.

The second circulation unit 6 includes a second circulation conduit 60, a second storage tank 61, a second circulation pump 62, an evaporation unit 70, and the like. The second circulation conduit 60 includes a return pipe 65 and a forward pipe 66.

The return pipe 65 is a pipe that transfers the mixed liquid discharged from the liquid discharge ports 24 of the gas-liquid counterflow contact unit 2 to the second storage tank 61. The gas-liquid counterflow contact unit 2 according to the present embodiment includes the two liquid discharge ports 24 (first liquid discharge port 24A and second liquid discharge port 24B). Therefore, the return pipe 65 includes a first branch pipe 65A and a second branch pipe 65B, and transfers the mixed liquid discharged from the liquid discharge ports 24A and 24B to the second storage tank 61. The first branch pipe 65A of the return pipe 65 is liquid-tightly connected to the first liquid discharge port 24A of the gas-liquid counterflow contact unit 2 through a joint FT. The second branch pipe 65B is liquid-tightly connected to the second liquid discharge port 24B of the gas-liquid counterflow contact unit 2 through a joint FT. The mixed liquid transferred from the liquid discharge ports 24 of the gas-liquid counterflow contact unit 2 by the return pipe 65 is stored in the second storage tank 61.

The forward pipe 66 includes a liquid feeding pipe 66A that transfers the mixed liquid stored in the second storage tank 61 to the evaporation unit 70, and a gas feeding pipe 66B that transfers the mixed-liquid-derived vapor generated by the evaporation unit 70 to the vapor introduction port 22 of the gas-liquid counterflow contact unit 2.

The second circulation pump 62 is connected to the liquid feeding pipe 66A of the forward pipe 66. When the second circulation pump 62 operates, a mixed liquid LqB stored in the second storage tank 61 is forcibly sent (for example, fed) to the liquid feeding pipe 66A, and the mixed liquid LqB is transferred to the evaporation unit 70 through the liquid feeding pipe 66A. Although the type of the second circulation pump 62 is not particularly limited, for example, a syringe pump and a diaphragm pump are usable.

For example, the evaporation unit 70 is formed as a microfluidic device in a chip form in which micro flow paths 71 in a micrometer scale are formed on a substrate 72. Although a shape of the substrate 72 of the evaporation unit 70 is not particularly limited, for example, the substrate 72 of the evaporation unit 70 has a chip form including a rectangular flat surface. As a material of the substrate 72 of the evaporation unit 70, borosilicate glass that has chemical resistance to organic chemical substances and heat resistance may be used. The plurality of linear micro flow paths 71 are arranged in parallel on the substrate 72 of the evaporation unit 70. Upstream ends and downstream ends of the micro flow paths 71 are respectively merged at an upstream-side merging unit 73 and a downstream-side merging unit 74. In the substrate 72 of the evaporation unit 70, a liquid introduction port 75 is formed so as to communicate with the upstream-side merging unit 73, and a vapor discharge port 76 is formed so as to communicate with the downstream-side merging unit 74. The number and arrangement of the micro flow paths 71 in the evaporation unit 70 are not particularly limited, and for example, the evaporation unit 70 may include the micro flow paths 71 extending in a meandering shape.

A flow path width of each of the micro flow paths 71 in the evaporation unit 70 can be 60 µm or more and 1000 µm or less, is preferably 80 µm or more and 700 µm or less, and is more preferably 100 µm or more and 500 µm or less. A flow path height of each of the micro flow paths 71 can be 60 µm or more and 1000 µm or less, is preferably 80 µm or more and 700 µm or less, and is more preferably 100 µm or more and 500 µm or less. A flow path length of each of the micro flow paths 71 can be 1 mm or more and 1000 mm or less, is preferably 5 mm or more and 500 mm or less, and is more preferably 10 mm or more and 100 mm or less.

The liquid feeding pipe 66A is liquid-tightly connected to the liquid introduction port 75 of the evaporation unit 70 through a joint FT. Further, one end of the gas feeding pipe 66B is air-tightly connected to the vapor discharge port 76 of the evaporation unit 70 through a joint FT. In addition, the other end of the gas feeding pipe 66B is air-tightly connected to the vapor introduction port 22 of the gas-liquid counterflow contact unit 2 through a joint FT. The evaporation unit 70 configured as described above introduces the mixed liquid LqB supplied through the liquid feeding pipe 66A from the liquid introduction port 75, and distributes the mixed liquid LqB to each of the micro flow paths 71 through the upstream-side merging unit 73.

The evaporation unit 70 includes an evaporation heater 77 that heats and evaporates the mixed liquid LqB flowing along the micro flow paths 71 (see Fig. 1). An aspect of the evaporation heater 77 is not particularly limited as long as the heater can evaporate the mixed liquid LqB flowing through the micro flow paths 71, and the evaporation heater 77 may be a planar heater provided on the substrate so as to cover upper surfaces or lower surfaces of the micro flow paths 71. In the above-described manner, the mixed liquid LqB flowing into the micro flow paths 71 of the evaporation unit 70 is evaporated in a process of flowing through the micro flow paths 71. The mixed-liquid-derived vapor generated in the micro flow paths 71 is merged at the downstream-side merging unit 74, and discharged from the vapor discharge port 76 to the gas feeding pipe 66B. The evaporation unit 70 can suitably evaporate the mixed liquid by heating the mixed liquid flowing through the micro flow paths 71 by the heater. Note that a setting temperature of the evaporation heater 77 is set to a temperature higher than a boiling point of a component having the lowest boiling point contained in the mixed liquid LqB, for example, can be 30°C or more and 400°C or less, is preferably 40°C or more and 350°C or less, and is more preferably 50°C or more and 300°C or less.

The mixed-liquid-derived vapor discharged to the gas feeding pipe 66B is supplied to the vapor introduction port 22 of the gas-liquid counterflow contact unit 2 through the gas feeding pipe 66B. The gas feeding pipe 66B preferably has a warm keeping function of keeping the mixed-liquid-derived vapor flowing through the inside warm to suppress condensation during transfer. Alternatively, the second circulation unit 6 may include a warm keeping member 67 that keeps the gas feeding pipe 66B warm (see Fig. 1). The warm keeping member 67 is not particularly limited as long as the member can suppress recondensation of the vapor transferred by the gas feeding pipe 66B by keeping the gas feeding pipe 66B warm.

In the micro gas-liquid counterflow contact device 1, the temperature adjustment heaters 35 in the gas-liquid counterflow contact unit 2, the first circulation pump 52 in the first circulation unit 5, the second circulation pump 62 and the evaporation heater 77 in the second circulation unit 6, and the like are controlled by a control apparatus 100 (see Fig. 1).

The control apparatus 100 may be a general computer. The control apparatus 100 includes a communication interface (I/F), a memory device, an input/output device, a processor, and the like. The communication I/F may be, for example, a network card or a communication module, and communicates with another computer based on a predetermined protocol. The memory device may be a main memory such as a RAM (Random Access Memory) and a ROM (Read Only Memory), or an auxiliary memory (secondary memory) such as an HDD (Hard-Disk Drive), an SSD (Solid State Device), and a flash memory. The main memory temporarily stores programs to be read out by the processor and information to be transmitted to/received from another computer, and secures a work area for the processor. The auxiliary memory stores programs to be executed by the processor, information to be transmitted to/received from another computer, and the like. The input/output device is a user interface, for example, an input device such as a keyboard and a mouse, an output device such as a monitor, and an input/output device such as a touch panel. The processor is a calculation processing device such as a CPU (Central Processing Unit), and executes programs. Note that various kinds of devices of the micro gas-liquid counterflow contact device 1 are not required to be controlled by the control apparatus 100. In this respect, the control apparatus 100 is an optional element.

In the micro gas-liquid counterflow contact device 1 configured as described above, in a preparation step before operation (running) starts, the mixed liquids LqA and LqB as target of unit operation are respectively stored in the first storage tank 51 and the second storage tank 61. Here, the mixed liquids are represented by different reference symbols "LqA and LqB" in order to distinguish places where the respective mixed liquids are stored, and the mixed liquids LqA and LqB may have the same composition as a matter of course.

Next, a working state (operation state) of the micro gas-liquid counterflow contact device 1 is described. Working (operation) of the micro gas-liquid counterflow contact device 1 is performed when the control apparatus 100 controls operation of various kinds of devices (first circulation pump 52, second circulation pump 62, temperature adjustment heaters 35, and evaporation heater 77) of the micro gas-liquid counterflow contact device 1.

In the following, as one aspect of the micro gas-liquid counterflow contact device 1 according to the present embodiment, an example in which the micro gas-liquid counterflow contact device 1 is used as a "micro distillation device" is described. In this case, distillation operation is performed on the mixed liquid that contains at least two types of components different in boiling point, by the gas-liquid counterflow contact unit 2. Therefore, the gas-liquid counterflow contact unit 2 can be regarded as a "distillation unit". The micro gas-liquid counterflow contact device 1 serving as the micro distillation device performs distillation operation on the mixed liquid that contains at least two types of components different in boiling point, to separate a specific target component from the other component. The aspect in which the micro gas-liquid counterflow contact device 1 is used as the "micro distillation device" as described below is merely one aspect of the micro gas-liquid counterflow contact device 1 as a matter of course. In other words, the micro gas-liquid counterflow contact device 1 is not limited to a specific aspect as long as the micro gas-liquid counterflow contact device 1 includes a gas-liquid contact flow path that brings the gas and the liquid into gas-liquid contact with each other. An object for bringing the gas and the liquid into gas-liquid contact with each other in the gas-liquid contact flow path is not limited to distillation, and another unit operation may be performed.

When the micro gas-liquid counterflow contact device 1 operates, the mixed liquids LqA and LqB stored in the first storage tank 51 of the first circulation unit 5 are transferred to the liquid introduction ports 21 of the gas-liquid counterflow contact unit 2 through the forward pipe 56 of the first circulation unit 5.

In addition, the mixed liquid LqB stored in the second storage tank 61 of the second circulation unit 6 is transferred to the evaporation unit 70 through the liquid feeding pipe 66A. The mixed liquid LqB transferred to the evaporation unit 70 is evaporated by being heated by the evaporation heater 77 in the process of flowing through the micro flow paths 71, and turns into the mixed-liquid-derived vapor. The mixed-liquid-derived vapor generated by the evaporation unit 70 is transferred to the vapor introduction port 22 of the gas-liquid counterflow contact unit 2 through the gas feeding pipe 66B in a warm state.

The mixed liquid LqA introduced from the first liquid introduction port 21A and the second liquid introduction port 21B of the gas-liquid counterflow contact unit 2 is guided to the first end 23A side of the gas-liquid contact flow path 23 through the first liquid introduction path 26A and the second liquid introduction path 26B. Thereafter, the mixed liquid flows down toward the second end 23B of the gas-liquid contact flow path 23 positioned on the lower side in the vertical direction, along the liquid flowing regions RL formed on the flow path wall surfaces of the gas-liquid contact flow path 23.

More specifically, the mixed liquid LqA introduced from the first liquid introduction port 21A is guided to the first flow path wall surface 231 through the first liquid introduction path 26A at the first end 23A of the gas-liquid contact flow path 23. Further, the mixed liquid LqA introduced from the second liquid introduction port 21B is guided to the second flow path wall surface 232 through the second liquid introduction path 26B at the first end 23A of the gas-liquid contact flow path 23. As described above, in use, the gas-liquid counterflow contact unit 2 is disposed such that the first end 23A side of the gas-liquid contact flow path 23 is positioned on the upper side (directed upward) in the vertical direction, and the second send 23B side is positioned on the lower side (directed downward) in the vertical direction. Therefore, the mixed liquid LqA guided to the first flow path wall surface 231 and the second flow path wall surface 232 can be caused to flow downward in the vertical direction along the surfaces of the flow path wall surfaces 231 and 232 by gravity.

In the present embodiment, the cross-sectional area of the gas-liquid contact flow path 23 is determined such that the entire flow-path cross-section of the gas-liquid contact flow path 23 is not blocked by the mixed liquid LqA flowing through the gas-liquid contact flow path 23, in other words, the hollow vapor flowing region RG remains on the cross-section center side of the gas-liquid contact flow path 23. As one aspect, the flow path width and the flow path height of each of the liquid introduction paths 26 and the liquid discharge paths 27 of the gas-liquid counterflow contact unit 2 are respectively designed to about 400 µm and about 2000 µm. Further, a liquid film thickness TH1 (see Fig. 4) of the mixed liquid flowing down along each of the flow path wall surfaces 231 and 232 of the gas-liquid contact flow path 23 is designed to, for example, several tens of µm to several hundreds of µm, and the mixed liquid is sufficiently discharged. Under such design conditions, to sufficiently secure the vapor flowing region RG for causing the vapor to flow as a counterflow in a vertical upward direction opposite to the flowing direction of the mixed liquid, for example, an aspect in which the cross-section of the gas-liquid contact flow path 23 is a square cross-section with one side of 2 mm can be suitably employed.

On the other hand, the mixed-liquid-derived vapor transferred to the vapor introduction port 22 of the gas-liquid counterflow contact unit 2 by the second circulation unit 6 flows into the gas-liquid contact flow path 23 from the second end 23B side positioned on the lower side in the vertical direction through the vapor introduction path 28. The mixed-liquid-derived vapor flowed into the gas-liquid contact flow path 23 flows to the first end 23A side of the gas-liquid contact flow path 23 (namely, vertically upward) along the gas-liquid contact flow path 23. In other words, the mixed-liquid-derived vapor supplied to the gas-liquid counterflow contact unit 2 by the second circulation unit 6 flows through the gas-liquid contact flow path 23 as a counterflow to the mixed liquid LqA supplied to the gas-liquid counterflow contact unit 2 by the first circulation unit 5.

As described above, gas-liquid counterflow contact using gravity by the mixed liquid LqA and the mixed-liquid-derived vapor is performed in the gas-liquid contact flow path 23, which makes it possible to efficiently perform heat exchange and substance transfer between the mixed liquid LqA and the mixed-liquid-derived vapor. Further, as described above, the gas-liquid counterflow contact unit 2 includes the temperature adjustment mechanism 3 that forms the predetermined temperature gradient in which the temperature is gradually reduced from the second end 23B side to the first end 23A side of the gas-liquid contact flow path 23. The control apparatus 100 controls the temperature adjustment heaters 35 of the temperature adjustment mechanism 3, which makes it possible to form an appropriate temperature distribution in which the temperature is gradually reduced from the second end 23B (lower end) side to the first end 23A (upper end) side of the gas-liquid contact flow path 23. For example, control may be performed such that the temperature of the gas-liquid contact flow path 23 is transited in a temperature range higher than a boiling point of a target component to be separated by the distillation operation and at a temperature lower than a boiling point of the other component.

As a result, the mixed-liquid-derived vapor flowing through the vapor flowing region RG of the gas-liquid contact flow path 23 from the second end 23B side to the first end 23A side (vertically upward) is gradually cooled, and the other component higher in boiling point than the target component contained in the mixed-liquid-derived vapor is condensed. The condensed other component flows down along the liquid flowing regions RL (flow path wall surfaces 231 and 232) together with the mixed liquid LqA flowing from the first end 23A side of the gas-liquid contact flow path 23. On the other hand, the target component contained in the mixed-liquid-derived vapor is discharged from the vapor discharge port 25 through the vapor discharge path 29 in a state of being maintained in a vapor phase.

As for the mixed liquid LqA flowing down along the liquid flowing regions RL (flow path wall surfaces 231 and 232) of the gas-liquid contact flow path 23, since the temperature is gradually increased toward the second end 23B side of the gas-liquid contact flow path 23, the target component contained in the mixed liquid LqA is phase-changed to the vapor in the process. In the above-described manner, the vapor of the target component flows through the vapor flowing region RG, and is discharged from the vapor discharge port 25 through the vapor discharge path 29. Out of the mixed liquid LqA flowing down through the liquid flowing regions RF (flow path wall surfaces 231 and 232, the other component higher in boiling point than the target component is concentrated and reaches the second end 23B of the gas-liquid contact flow path 23, and is discharged from the liquid discharge ports 24 (first liquid discharge port 24A and second liquid discharge port 24B) through the liquid discharge paths 27.

The mixed-liquid-derived vapor (vapor in which target component is concentrated) discharged from the vapor discharge port 25 of the gas-liquid counterflow contact unit 2 is condensed by being cooled in the process of flowing through the return pipe 55 of the first circulation unit 5. The condensate thus obtained is stored in the first storage tank 51. In other words, the condensate transferred through the return pipe 55 of the first circulation unit 5 is mixed with the mixed liquid LqA stored in the first storage tank 51, and then, the resultant liquid is circulated to the liquid introduction ports 21 of the gas-liquid counterflow contact unit 2 through the forward pipe 56 again.

The mixed liquid (mixed liquid in which component other than target component is concentrated) discharged from the liquid discharge port 24 of the gas-liquid counterflow contact unit 2 is stored in the second storage tank 61 through the return pipe 65 of the second circulation unit 6. In other words, the mixed liquid (mixed liquid in which component other than target component is concentrated) discharged from the liquid discharge ports 24 of the gas-liquid counterflow contact unit 2 is mixed with the mixed liquid LqB stored in the second storage tank 61, and then, the resultant mixed liquid is transferred to the evaporation unit 70 through the liquid feeding pipe 66A and is phase-changed to the vapor. Thereafter, the vapor circulates to the vapor introduction port 22 of the gas-liquid counterflow contact unit 2 again.

The micro gas-liquid counterflow contact device 1 sequentially (continuously) performs circulation using the first circulation unit 5 and circulation using the second circulation unit 6 in a steady operation state. As a result, the mixed liquid in which the target component is concentrated can be stored in the first storage tank 51 (also referred to as reflux tank) of the micro gas-liquid counterflow contact device 1. In other words, the mixed liquid in which the target component is concentrated can be suitably recovered from the first storage tank 51 (reflux tank). Further, the mixed liquid in which the component other than the target component is concentrated can be stored in the second storage tank 61 (also referred to as bottom tank). Therefore, the mixed liquid in which the component other than the target component is concentrated can be suitably recovered from the second storage tank 61 (bottom tank). At this time, it can be said that the separation operation using the micro gas-liquid counterflow contact device 1 is efficient as the concentration of the target component is higher in the mixed liquid recovered from the first storage tank 51 and as the concentration of the target component is lower (concentration of component other than target component is higher) in the mixed liquid recovered from the second storage tank 61. Further, in the micro gas-liquid counterflow contact device 1 according to the present embodiment, since the gas-liquid counterflow contact using gravity in the gas-liquid contact flow path 23 is realized, it is possible to efficiently bring the vapor rising vertically upward in the vapor flowing region RG and the mixed liquid flowing down vertically downward in the liquid flowing regions RL using the flow path wall surfaces 231 and 232 as the wet walls into contact with each other, and to promote heat transfer and substance transfer between the gas and the liquid. As a result, it is possible to efficiently separate the target component and the other component contained in the mixed fluid (mixed liquid and vapor).

The micro gas-liquid counterflow contact device 1 continuously (sequentially) circulates the mixed liquid in which the target component is concentrated by the first circulation unit 5, to the gas-liquid counterflow contact unit 2. Further, the micro gas-liquid counterflow contact device 1 continuously (sequentially) circulates the mixed liquid in which the component other than the target component is concentrated by the second circulation unit 6, to the gas-liquid counterflow contact unit 2. The micro gas-liquid counterflow contact device 1 can continuously and repeatedly circulate the mixed liquid in which the target component is concentrated and the vapor obtained by evaporating the mixed liquid in which the other component is concentrated, to the gas-liquid counterflow contact unit 2 by using such two systems of the circulation units 5 and 6, and perform gas-liquid contact in the gas-liquid contact flow path 23. Thus, it is possible to enhance a separation degree of the target component and the other component contained in the mixed fluid (mixed liquid and vapor).

The gas-liquid counterflow contact unit 2 according to the present embodiment includes the plurality of liquid introduction ports 21A and 21B as described above. Further, the gas-liquid counterflow contact unit 2 can guide the mixed liquid to the liquid flowing regions RL of the gas-liquid contact flow path 23 through the plurality of liquid introduction paths 26A and 26B respectively corresponding to the liquid introduction ports 21A and 21B. This makes it possible to suitably secure the flow rate of the mixed liquid in the gas-liquid contact flow path 23. At this time, it is configured such that the mixed liquid introduced from the liquid introduction paths 26A and 26B is respectively guided to the different flow path wall surfaces 231 and 232 forming the gas-liquid contact flow path 23. This makes it possible to secure the flow rate of the mixed liquid while suppressing inhibition of flow of the vapor in the vapor flowing region RG of the gas-liquid contact flow path 23.

Since the liquid introduction paths 26 of the gas-liquid counterflow contact unit 2 are formed as the micro flow paths, it is possible to supply the mixed liquid of an appropriate flow rate to the gas-liquid contact flow path 23 through the liquid introduction paths 26. As a result, the liquid film thickness of the mixed liquid flowing down along the flow path wall surfaces 231 and 232 (liquid flowing regions RL) of the gas-liquid contact flow path 23 is easily controlled in the micrometer scale. Furthermore, since the liquid discharge paths 27 of the gas-liquid counterflow contact unit 2 are formed as the micro flow paths, the flow paths for discharging the mixed liquid flowing down on the flow path wall surfaces 231 and 232 (liquid flowing regions RL) with the liquid film thickness in the micrometer scale can be formed to have appropriate sizes.

The gas-liquid counterflow contact unit 2 includes the temperature adjustment mechanism 3 that includes the temperature adjustment heaters 35 and the heat conductive members 31 to 34 for conducting the heat of the temperature adjustment heaters 35 to the substrate B, and can form, in the gas-liquid contact flow path 23, the predetermined temperature gradient (temperature distribution) in which the temperature is gradually reduced from the second end 23B (lower end) side to the first end 23A (upper end) side of the gas-liquid contact flow path 23. Accordingly, even under the condition that the thermal environment of the gas-liquid contact flow path 23 is easily affected by the outside temperature due to small capacity of the gas-liquid contact flow path 23 of the gas-liquid counterflow contact unit 2 and the like, an appropriate thermal environment can be formed in the gas-liquid contact flow path 23, and the unit operation (for example, distillation operation) performed in the gas-liquid counterflow contact unit 2 can be suitably performed. More specifically, separation of a low-boiling component and a high-boiling component by the gas-liquid counterflow contact can be suitably performed without totally condensing the vapor flowing through the vapor flowing region RG of the gas-liquid contact flow path 23. In the present embodiment, the temperature control is preferably performed using the temperature adjustment mechanism 3 such that the temperature at each of points previously set along the axial direction (extending direction) of the gas-liquid contact flow path 23 becomes a predetermined temperature.

An existing distillation column has a complicated structure. Therefore, it may be difficult to check an internal flowing state and a defect (such as drift in packed column, blocking by polymer, flooding, and weeping). In contrast, in the temperature adjustment mechanism 3 according to the present embodiment, the clearances (slits for visual recognition) SL extending in the up-down direction are formed between the first heat conductive member 31 and the second heat conductive member 32 and between the third heat conductive member 33 and the fourth heat conductive member 34. Therefore, even during operation of the micro gas-liquid counterflow contact device 1, the state of the gas-liquid contact flow path 23 is visible through the clearances SL in real time, which enables visualization of the flowing states of the mixed liquid and the vapor flowing through the gas-liquid contact flow path 23.

Note that the working time (operation time) of the micro gas-liquid counterflow contact device 1 is not particularly limited, and is freely settable.

In the micro gas-liquid counterflow contact device 1, when a container capacity of the first storage tank 51 and a container capacity of the second storage tank 61 are excessively large, a time necessary for stabilizing the concentration of the mixed liquid stored in each of the tanks 51 and 61 (to final state) is increased, whereas when the container capacities are excessively small, it may be difficult to perform stable continuous operation. The container capacities of the first storage tank 51 and the second storage tank 61 are preferably designed in consideration of such circumstances. For example, the storage capacity of the first storage tank 51 can be 30 µL or more and 3000 µL or less, is preferably 40 µL or more and 2000 µL or less, and is more preferably 50 µL or more and 1000 µL or less. The storage capacity of the second storage tank 61 can be 30 µL or more and 3000 µL or less, is preferably 40 µL or more and 2000 µL or less, and is more preferably 50 µL or more and 1000 µL or less.

When the liquid feeding amount of the mixed liquid fed by each of the first circulation pump 52 and the second circulation pump 62 is excessively small, a time until the concentration of the mixed liquid stored in each of the storage tanks 51 and 61 reaches the final state may be increased. The liquid feeding amount by each of the first circulation pump 52 and the second circulation pump 62 is preferably determined such that a liquid level in each of the storage tanks 51 and 61 is stable and is not much changed during operation of the micro gas-liquid counterflow contact device 1. When the liquid feeding amount by the second circulation pump 62 is excessively large (liquid feeding speed is excessively high), the liquid feeding amount exceeds vaporization/evaporation capacity of the evaporation unit 70, and the liquid may be introduced to the vapor introduction port 22 of the gas-liquid counterflow contact unit 2. The liquid feeding amount by each of the first circulation pump 52 and the second circulation pump 62 is preferably designed in consideration of such circumstances. For example, the liquid feeding amount of the mixed liquid fed by the first circulation pump 52 can be 5 µL/min or more and 1000 µL/min or less, is preferably 8 µL/min or more and 500 µL/min or less, and is more preferably 10 µL/min or more and 300 µL/min or less. Further, the liquid feeding amount of the mixed liquid fed by the second circulation pump 62 can be 5 µL/min or more and 1000 µL/min or less, is preferably 8 µL/min or more and 500 µL/min or less, and more preferably 10 µL/min or more and 300 µL/min or less.

Although the micro gas-liquid counterflow contact device 1 according to the present embodiment can perform distillation (rectification) operation of the mixed liquid of three or more components different in boiling point, an aspect in which distillation operation of a mixed liquid of two components (low-boiling component and high-boiling component) is described. In this case, in a process in which the mixed-liquid-derived vapor containing the low-boiling component and the high-boiling component supplied to the gas-liquid counterflow contact unit 2 by the second circulation unit 6 flows through the vapor flowing region RG of the gas-liquid contact flow path 23 from the second end 23B side to the first end 23A side (vertically upward), the high-boiling component of the mixed-liquid-derived vapor is condensed, and the condensate of the high-boiling component flows down along the liquid flowing regions RL (flow path wall surfaces 231 and 232) together with the mixed liquid flowing from the first end 23A side of the gas-liquid contact flow path 23, and is finally discharged from the liquid discharge ports 24. Further, the vapor in which the concentration of the low-boiling component is increased due to separation from the high-boiling component is discharged from the vapor discharge port 25 through the vapor discharge path 29.

In addition, in a process in which the mixed liquid containing the low-boiling component and the high-boiling component supplied to the gas-liquid counterflow contact unit 2 by the first circulation unit 5 flows down in the liquid flowing regions RL (flow path wall surfaces 231 and 232) of the gas-liquid contact flow path 23, the low-boiling component of the mixed liquid is phase-changed to the vapor. The vapor of the low-boiling component is discharged from the vapor discharge port 25 through the vapor discharge path 29 together with the vapor flowing upward in the vapor flowing region RG. On the other hand, the high-boiling component contained in the mixed liquid supplied to the gas-liquid counterflow contact unit 2 by the first circulation unit 5 is concentrated in a process of flowing down in the liquid flowing regions RL (flow path wall surfaces 231 and 232), reaches the second end 23B of the gas-liquid contact flow path 23, and is then discharged from the liquid discharge ports 24 through the liquid discharge paths 27. When such distillation operation is continuously performed, the mixed liquid in which the concentration of the low-boiling component is increased is stored in the first storage tank 51 (reflux tank), and the mixed liquid in which the concentration of the high-boiling component is increased is stored in the second storage tank 61 (bottom tank). In other words, the mixed liquid in which purities of the low-boiling component and the high-boiling component are increased can be stored and recovered in the storage tanks 51 and 61, respectively.

### <Examples>

The present disclosure is specifically described below with reference to Examples. However, the present disclosure is not limited to aspects of Examples described below.

In Examples, the micro gas-liquid counterflow contact device 1 described with reference to Figs. 1 to 5 was used to perform total reflux distillation on a mixed liquid containing acetic acid and ethyl acetate.

The micro gas-liquid counterflow contact device 1 was operated (run) in a state where the gas-liquid counterflow contact unit 2 was installed such that the first end 23A side of the gas-liquid contact flow path 23 in the gas-liquid counterflow contact unit 2 was positioned on the upper side (directed upward) in the vertical direction, and the second end 23B side was positioned on the lower side (directed downward) in the vertical direction.

Devices used in Examples are as follows.
- Circulation pump (liquid feeding pump): smooth flow pump Q, model Q1-5-KR-UP-S-IMTT (manufactured by TACMINA CORPORATION)
- Distributor: standard chip ICC-SY500 (manufactured by Institute of Microchemical Technology Co., Ltd.)
- Circulation conduit: poly ether ether ketone tube (inner diameter of 260 µm, manufactured by Institute of Microchemical Technology Co., Ltd.)
- First storage tank (reflux tank): capacity of 0.6 mL (manufactured by NICHIDEN-RIKA GLASS CO., LTD.)
- Second storage tank (bottom tank): capacity of 0.6 mL (manufactured by NICHIDEN-RIKA GLASS CO., LTD.)
- Temperature adjustment heater: 2 cm × 2 cm type (manufactured by MIYO Technology Co., Ltd.)
- Evaporation heater: IACF-THT03050 (manufactured by TAIYA International Technology Co., Ltd.)

### [Evaporation Unit]

The evaporation unit 70 in which ten micro flow paths 71 were arranged in parallel on the substrate 72 was used. Each of the micro flow paths 71 had a flow path width of 150 µm, a flow path height (depth) of 50 µm, and a flow path length of 60 mm, and borosilicate glass was used as the material of the substrate 72.

### [Gas-Liquid Counterflow Contact Unit (Distillation Unit)]

Borosilicate glass was used for the substrate B of the gas-liquid counterflow contact unit 2. The gas-liquid counterflow contact unit 2 used the substrate B having a lateral width of 30 mm and a height of 70 mm.

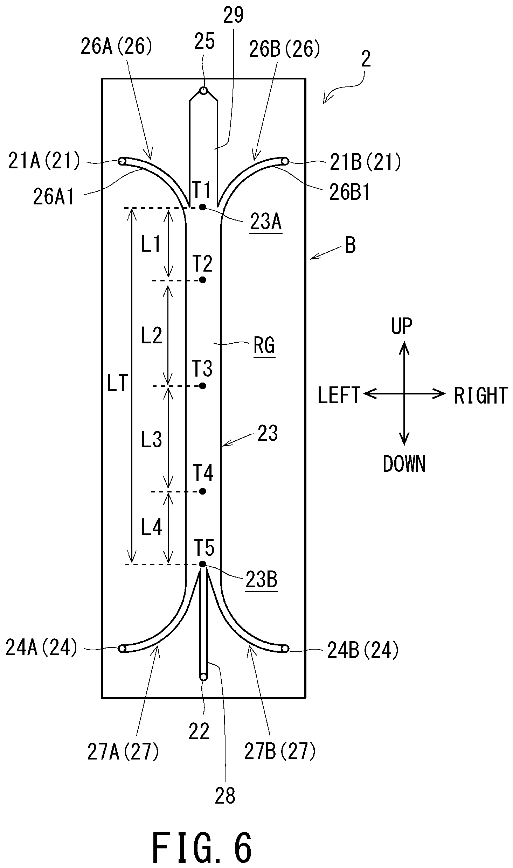

The flow-pass cross-section of the gas-liquid contact flow path 23 was a square cross-section with one side of 2 mm, and a flow path length (reference symbol LT in Fig. 6) was 50 mm. Each of the liquid introduction paths 26 and the liquid discharge paths 27 was formed as a micro flow path having a flow path width of 400 µm and a flow path height (depth) of 2000 µm (2 mm).

The liquid film thickness of the mixed liquid flowing down on the flow path wall surfaces of the gas-liquid contact flow path 23 was adjusted to a range of several tens of µm to several hundreds of µm.

### [Operation and Distillation Condition]

Table 1 illustrates specific operation and distillation conditions in Examples.

As a preparation step before the distillation operation by the micro gas-liquid counterflow contact device 1 was started, the mixed liquid was stored in the first storage tank 51 (reflux tank) and the second storage tank 61 (bottom tank).

100 µL of the mixed liquid of acetic acid and ethyl acetate, obtained by mixing ethyl acetate such that a concentration of acetic acid was 30.0 mass% was stored in the first storage tank 51 (reflux tank).

100 µL of the mixed liquid of acetic acid and ethyl acetate, obtained by mixing ethyl acetate such that a concentration of acetic acid was 30.0 mass% was stored in the second storage tank 61 (bottom tank).

Note that acetic acid and ethyl acetate manufactured by Honeywell Japan Ltd. were used in Examples.

In the distillation operation according Examples, the first circulation pump 52, the second circulation pump 62, the temperature adjustment heaters 35, and the evaporation heater 77 in the micro gas-liquid counterflow contact device 1 were operated, and the mixed liquid stored in each of the first storage tank 51 (reflux tank) and the second storage tank 61 (bottom tank) was fed to the gas-liquid counterflow contact unit 2 at flow rates illustrated in Table 1. After an operation time (experiment time) illustrated in Table 1 elapsed from start of the operation, the operation of the micro gas-liquid counterflow contact device 1 was stopped.

Table 1 illustrates results obtained by measuring temperatures at the temperature measurement points T1 to T5 (more specifically, surface temperatures of substrate (glass) at temperature measurement points T1 to T5) of the gas-liquid contact flow path 23 in the gas-liquid counterflow contact unit 2 during operation of the micro gas-liquid counterflow contact device 1. Fig. 6 is a diagram for explaining the temperature measurement points T1 to T5. The temperature measurement points T1 to T5 are set with intervals along the axial direction in which the gas-liquid contact flow path 23 extends. The temperature measurement points T1 to T5 are set on an axis of the gas-liquid contact flow path 23. The temperature measurement point T1 is a measurement point positioned at the first end 23A (upper end) of the gas-liquid contact flow path 23, namely, at a position where the gas-liquid contact flow path 23 is merged with the liquid introduction paths 26 (26A and 26B). The temperature measurement point T5 is a measurement point positioned at the second end 23B (lower end) of the gas-liquid contact flow path 23, namely, at a position where the gas-liquid contact flow path 23 is branched to the liquid discharge paths 27 (27A and 27B). The temperature measurement point T3 is a measurement point set at a center position between the temperature measurement points T1 and T5 on the axis of the gas-liquid contact flow path 23. The temperature measurement point T2 is a measurement point set between the temperature measurement points T1 and T3 and is set at a position separated by 10 mm from the temperature measurement point T1 toward the temperature measurement point T3. The temperature measurement point T4 is a measurement point set between the temperature measurement points T5 and T3 and is set at a position separated by 10 mm from the temperature measurement point T5 toward the temperature measurement point T3. Reference numerals L1 to L4 in Fig. 6 denote separation dimensions among the temperature measurement points along the axial direction of the gas-liquid contact flow path 23. In Examples, L1 and L4 were set to 10 mm, and L2 and L3 were set to 15 mm. A sum of L1 to L4 is denoted by a reference symbol LT, and a length of the sum that is 50 mm is equal to the total length of the gas-liquid contact flow path 23.

The distillation operation was performed on each of Examples 1 to 3 having different distillation conditions, a concentration of ethyl acetate and a concentration of acetic acid in the mixed liquid recovered to the first storage tank 51 (reflux tank), a concentration of ethyl acetate and a concentration of acetic acid in the mixed liquid recovered to the second storage tank 61 (bottom tank), the number of theoretical plates, a height equivalent of one theoretical plate (HETP) were determined. Table 2 illustrates results in Examples.

A method of measuring the concentration of acetic acid and the concentration of ethyl acetate in a reflux liquid and bottoms obtained in each of Examples is as follows.

### [Method of Measuring Concentration of Acetic Acid]

The concentration of acetic acid was measured by titration analysis using 0.05 mol/L of a sodium hydroxide aqueous solution, and was calculated from a neutralization point in pH variation. Measurement conditions are as follows.
- Titration reagent: 0.05 mol/L of sodium hydroxide aqueous solution (manufactured by Honeywell Japan Ltd.)
- Measurement instrument: pH meter, model PB-10 (manufactured by Sartorius AG)
- Measurement temperature: 25°C (room temperature)

### [Method of Measuring Concentration of Ethyl Acetate]

The concentration of ethyl acetate was calculated as a difference between 100 mass% and the concentration of acetic acid.

**[Table 1]**

| | | | Example 1 | Example 2 | Example 3 |
|---|---|---|---|---|---|
| Charge composition | Ethyl acetate | wt% | 70 | 70 | 70 |
| | Acetic acid | wt% | 30 | 30 | 30 |
| Amount of liquid charged in reflux tank | | µL | 100 | 100 | 250 |
| Amount of liquid charged in bottom tank | | µL | 400 | 400 | 250 |
| Amount of liquid fed from reflux tank | | µL/min | 20 | 20 | 20 |
| Amount of liquid fed from bottom tank | | µL/min | 80 | 80 | 80 |
| Heating temperature of temperature adjustment heater | | °C | 100 | 100 | 100 |
| Heating temperature of evaporation heater | | °C | 90 | 90 | 90 |
| Temperature of gas-liquid contact flow path | T1 | °C | 75.6 | 75.6 | 75.6 |
| | T2 | °C | 76.4 | 76.4 | 76.4 |
| | T3 | °C | 78.1 | 78.1 | 78.1 |
| | T4 | °C | 82.8 | 82.8 | 82.8 |
| | T5 | °C | 83.2 | 83.2 | 83.2 |
| Operation time (experiment time) | | min | 24 | 45 | 120 |

**[Table 2]**

| | | | Example 1 | Example 2 | Example 3 |
|---|---|---|---|---|---|
| Amount of liquid stored in reflux tank | | µL | 100 | 100 | 210 |
| Amount of liquid stored in bottom tank | | µL | 340 | 350 | 210 |
| Reflux tank | Ethyl acetate | wt% | 93.2 | 93.1 | 93.1 |
| | Acetic acid | wt% | 6.8 | 6.9 | 6.9 |
| Bottom tank | Ethyl acetate | wt% | 56.0 | 51.8 | 39.6 |
| | Acetic acid | wt% | 44.0 | 48.2 | 60.4 |
| Number of theoretical plates | | plate | 1.7 | 1.9 | 2.3 |
| HETP | | mm | 29 | 26 | 22 |

### [Comparative Examples]

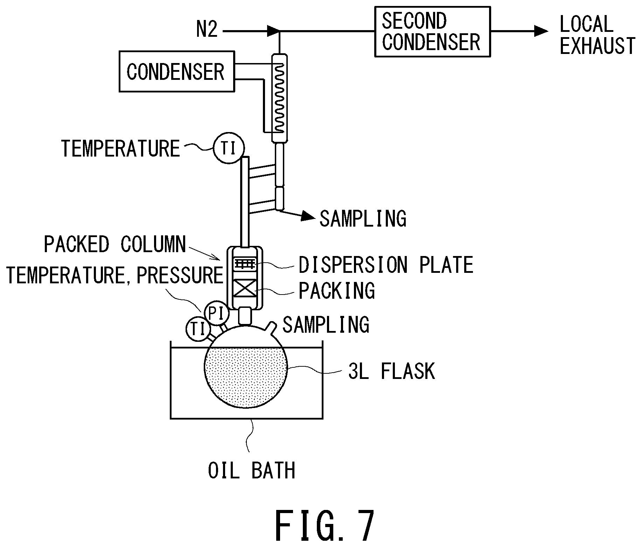

Next, Comparative Examples are described. In Comparative Examples, an experimental apparatus using a flask illustrated in Fig. 7 was used to perform total reflux distillation of acetic acid (99.7 wt%; FUJIFILM Wako Pure Chemical Corporation) and ethyl acetate (99.9 GC area%; manufactured by Daicel Corporation)

Devices used in Comparative Examples are as follows.
- Flask having capacity of 3 L (manufactured by Asahi Glassplant Inc.)
- Packed column (manufactured by Asahi Glassplant Inc.)
- Condenser (manufactured by Asahi Glassplant Inc.)

The flask used in the distillation operation according to Comparative Examples is connected to the packed column positioned at an upper part. The packed column includes a regular packing (Sulzer EX laboratory packing, inner diameter of 50 mm, packed length of 55 mm; Sulzer Chemtech Ltd.) and a dispersion plate. A gas flowing pipe through which the gas flows is connected to the upper part of the packed column, and the condenser is connected to an upper part of the gas flowing pipe. In the distillation operation according to Comparative Examples, the flask was heated by an oil bath to vaporize a mixed liquid in the flask, and the gas flowing through the gas flowing pipe was condensed by being cooled by the condenser.

### [Operation and Distillation Condition]

Table 3 illustrates specific operation and distillation conditions in Comparative Examples.

As a preparation step before the distillation operation according to Comparative Examples was started, 2.9 L of the mixed liquid obtained by mixing ethyl acetate such that a concentration of acetic acid was 30.0 mass% was stored in the flask.

The total reflux distillation was performed on the mixed liquid of acetic acid and ethyl acetate according to Comparative Examples 1 to 3 (see Table 3) having different distillation conditions, and a temperature of the oil bath was adjusted such that a flow rate of the reflux liquid become a predetermined flow rate. The reflux liquid and the mixed liquid in the flask were sampled, and a concentration of ethyl acetate and a concentration of acetic acid in the reflux liquid, a concentration of ethyl acetate and a concentration of acetic acid in the mixed liquid in the flask, the number of theoretical plates, a height equivalent of one theoretical plate (HETP) were determined. Table 4 illustrates results in Comparative Examples.

A method of measuring the concentration of acetic acid and the concentration of ethyl acetate in the reflux liquid and the mixed liquid in the flask obtained in each of Comparative Examples is as follows. The concentration of ethyl acetate was calculated as a difference between 100 mass% and the concentration of acetic acid.

### [Method of Measuring Concentration of Acetic Acid in Reflux Liquid]

The concentration of acetic acid was measured by titration analysis using 0.1 mol/L of a sodium hydroxide aqueous solution (manufactured by FUJIFILM Wako Pure Chemical Corporation), and was calculated from a neutralization point in color change. Measurement conditions are as follows.
- Titration reagent: 0.1 mol/L of sodium hydroxide aqueous solution (manufactured by FUJIFILM Wako Pure Chemical Corporation)
- Indicator: 1.0 w/v% phenolphthalein ethanol (90) solution (manufactured by FUJIFILM Wako Pure Chemical Corporation)
- Solvent: 99.7 wt% 2-propanol (manufactured by FUJIFILM Wako Pure Chemical Corporation)
- Measurement temperature: 25°C (room temperature)

### [Method of Measuring Concentration of Acetic Acid in Mixed liquid in Flask]

Measurement conditions of gas chromatography (GC) are as follows.
- Apparatus: gas chromatography (manufactured by Agilent Technologies, Inc.)
- Detector: thermal conductivity detector (manufactured by Agilent Technologies, Inc.)
- Column: DB-WAX (column size: length of 60 m, inner diameter: 0.53 mm, film thickness: 1.0 µm, manufactured by Agilent Technologies, Inc.)
- Vaporizing chamber temperature: 180°C
- Temperature rising: held at 100°C for 10 minutes, 10°C/min, held at 200°C for 10 minutes
- Carrier gas: He
- Split ratio: 20:1
- Total flow rate: 87 ml/min
- Injection amount: 1 µL
- Internal standard substance: 1,4-dioxane
- Analysis time: 30 minutes

**[Table 3]**

| | | | Comparative Example 1 | Comparative Example 2 | Comparative Example 3 |
|---|---|---|---|---|---|
| Charge composition | Ethyl acetate | wt% | 70 | 70 | 70 |
| | Acetic acid | wt% | 30 | 30 | 30 |
| Amount of liquid charged in flask | | L | 2.9 | 2.9 | 2.9 |
| Flow rate of reflux liquid | | mL/min | 24 | 28 | 75 |
| Oil bath temperature | | °C | 126 | 143 | 152 |
| Condenser refrigerant temperature | | °C | -10 | -10 | -10 |
| Operation time (experiment time) | | min | 300 | 240 | 300 |

**[Table 4]**

| | | | Comparative Example 1 | Comparative Example 2 | Comparative Example 3 |
|---|---|---|---|---|---|
| Reflux liquid | Ethyl acetate | wt% | 98.5 | 99.0 | 97.6 |
| | Acetic acid | wt% | 1.5 | 1.0 | 2.4 |
| Flask | Ethyl acetate | wt% | 67.8 | 68.9 | 68.9 |
| | Acetic acid | wt% | 32.2 | 31.1 | 31.1 |
| Number of theoretical plates | | plate | 1.1 | 1.0 | 0.9 |
| HETP | mm | 52 | 55 | 61 | |

It is found from comparison between the results in Examples (Table 2) and the results in Comparative Examples (Table 4) that the number of theoretical plates in Examples is large as compared with Comparative Examples. Therefore, it can be said that Examples are excellent in separation efficiency as compared with Comparative Examples. Further, the height equivalent of one theoretical plate (HETP) in Examples is small as compared with Comparative Examples, and it can be said that Examples are high in separation performance as compared with Comparative Examples.

### <Embodiment 2>

Next, Embodiment 2 of the micro gas-liquid counterflow contact device is described.

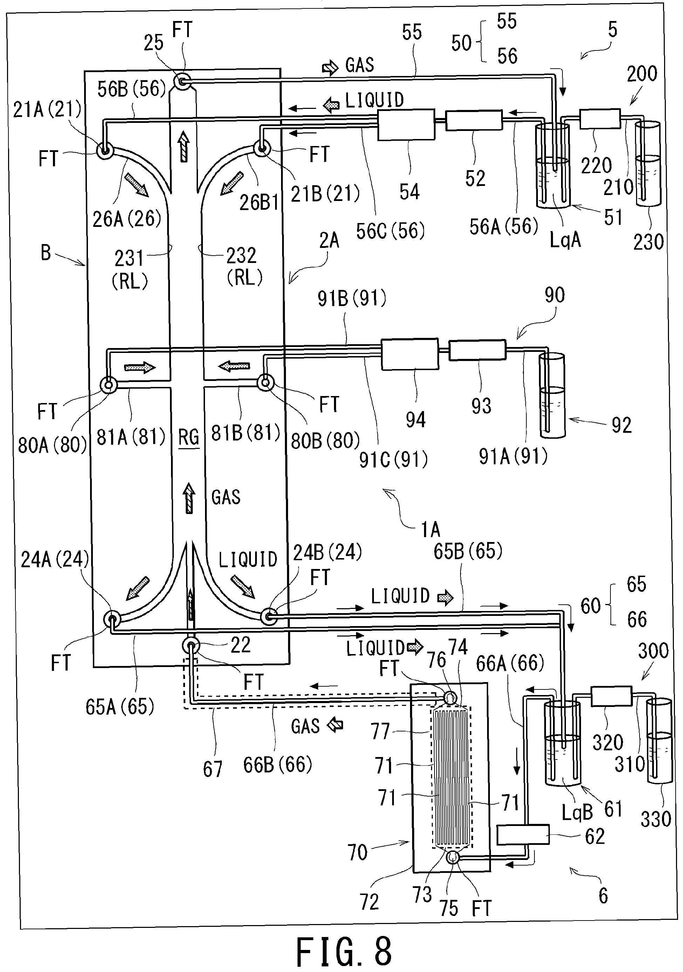

Fig. 8 is a diagram for explaining a micro gas-liquid counterflow contact device 1A according to Embodiment 2. In the micro gas-liquid counterflow contact device 1A illustrated in Fig. 8, a structure of a gas-liquid counterflow contact unit 2A is different from the structure of the gas-liquid counterflow contact unit 2 illustrated in Fig. 1. In the following, differences between Embodiments 1 and 2 are mainly described, and detailed description of common structures is omitted by using the same reference numerals.

The gas-liquid counterflow contact unit 2A according to Embodiment 2 further includes intermediate introduction ports 80 for introducing an additional mixed liquid at an intermediate position of the gas-liquid contact flow path 23, separately from the liquid introduction ports 21 disposed at the first end 23A of the gas-liquid contact flow path 23. In the example illustrated in Fig. 8, a first intermediate introduction port 80A and a second intermediate introduction port 80B are provided in the gas-liquid counterflow contact unit 2A. The gas-liquid counterflow contact unit 2A further includes intermediate introduction paths 81 allowing the intermediate introduction ports 80 and the gas-liquid contact flow path 23 to communicate with each other. In the example illustrated in Fig. 8, a first intermediate introduction path 81A allows the first intermediate introduction port 80A and the gas-liquid contact flow path 23 to communicate with each other, and a second intermediate introduction path 81B allows the second intermediate introduction port 80B and the gas-liquid contact flow path 23 to communicate with each other. The first intermediate introduction path 81A opens in the first flow path wall surface 231, and the second intermediate introduction path 81B opens in the second flow path wall surface 232.

As illustrated in Fig. 8, the micro gas-liquid counterflow contact device 1A includes an additional supply unit 90 that supplies the additional mixed liquid to the intermediate position of the gas-liquid contact flow path 23. The additional supply unit 90 includes a liquid feeding conduit 91, a third storage tank 92, a liquid feeding pump 93, a distributor 94, and the like. The liquid feeding conduit 91 is a pipe that transfers (supplies) the additional mixed liquid stored in the third storage tank 92, to the intermediate introduction ports 80 of the gas-liquid counterflow contact unit 2A. Although the type of the liquid feeding pump 93 is not particularly limited, for example, a syringe pump and a diaphragm pump are usable.

The liquid feeding conduit 91 includes a main pipe 91A positioned between the third storage tank 92 and the distributor 94, and a first branch pipe 91B and a second branch pipe 91C branched from the main pipe 91A through the distributor 94. One end side of the first branch pipe 91B is connected to the distributor 94, and the other end side thereof is connected to the first intermediate introduction port 80A of the gas-liquid counterflow contact unit 2A. One end side of the second branch pipe 91C is connected to the distributor 54, and the other end side thereof is connected to the second intermediate introduction port 80B of the gas-liquid counterflow contact unit 2A.

The liquid feeding pump 93 is connected to the main pipe 91A of the liquid feeding conduit 91. When the liquid feeding pump 93 operates, the mixed liquid stored in the third storage tank 92 is forcibly sent (fed) to the main pipe 91A. The mixed liquid is supplied to the first intermediate introduction port 80A of the gas-liquid counterflow contact unit 2A through the first branch pipe 91B, and is supplied to the second intermediate introduction port 80B of the gas-liquid counterflow contact unit 2A through the second branch pipe 91C.

Further, as illustrated in Fig. 8, the micro gas-liquid counterflow contact device 1A includes a first mixed liquid discharge unit 200 and a second mixed liquid discharge unit 300. The first mixed liquid discharge unit 200 includes a first liquid feeding conduit 210, a first liquid feeding pump 220, a first recovery tank 230, and the like. The first liquid feeding conduit 210 is a conduit connecting the first storage tank 51 and the first recovery tank 230, and the first liquid feeding pump 220 is connected in a middle of the first liquid feeding conduit 210. The second mixed liquid discharge unit 300 includes a second liquid feeding conduit 310, a second liquid feeding pump 320, a second recovery tank 330, and the like. The second liquid feeding conduit 310 is a conduit connecting the second storage tank 61 and the second recovery tank 330, and the second liquid feeding pump 320 is connected in a middle of the second liquid feeding conduit 310. When the first liquid feeding pump 220 operates, the mixed liquid stored in the first storage tank 51 is fed to the first recovery tank 230 through the first liquid feeding conduit 210, and is stored in the first recovery tank 230. Likewise, when the second liquid feeding pump 320 operates, the mixed liquid stored in the second storage tank 61 is fed to the second recovery tank 330 through the second liquid feeding conduit 310, and is stored in the second recovery tank 330. In the present embodiment, for example, the first liquid feeding pump 220 and the second liquid feeding pump 320 are sequentially (continuously) operated.

Although the type of each of the first liquid feeding conduit 210 and the second liquid feeding conduit 310 is not particularly limited, for example, a PEEK tube can be suitably used. Although the type of each of the first liquid feeding pump 220 and the second liquid feeding pump 320 is not particularly limited, for example, a syringe pump and a diaphragm pump are usable.

As described above, since the first intermediate introduction path 81A opens in the first flow path wall surface 231, and the second intermediate introduction path 81B opens in the second flow path wall surface 232, it is possible to sequentially supply the mixed liquid transferred by the additional supply unit 90 to the gas-liquid contact flow path 23 from side surfaces. In other words, it is possible to merge the additional mixed liquid introduced from the first intermediate introduction path 81A with the mixed liquid flowing down from the first end 23A side of the gas-liquid contact flow path 23 along the first flow path wall surface 231. Likewise, it is possible to merge the additional mixed liquid introduced from the second intermediate introduction path 81B with the mixed liquid flowing down from the first end 23A side of the gas-liquid contact flow path 23 along the second flow path wall surface 232. Further, the amount of liquid stored in the first storage tank 51 is increased by the mixed liquid sequentially supplied by the additional supply unit 90. Therefore, the mixed liquid may be sequentially discharged from the first storage tank 51 by the first mixed liquid discharge unit 200 such that the liquid level in the first storage tank 51 is constant. Likewise, the amount of liquid stored in the second storage tank 61 is increased by the mixed liquid sequentially supplied by the additional supply unit 90. Therefore, the mixed liquid may be sequentially discharged from the second storage tank 61 by the second mixed liquid discharge unit 300 such that the liquid level in the second storage tank 61 is constant. In other words, the additional supply unit 90 sequentially supplies the mixed liquid, and the first mixed liquid discharge unit 200 and the second mixed liquid discharge unit 300 sequentially discharge the mixed liquid, which makes it possible to sequentially obtain the mixed liquid in which the low-boiling component is concentrated and the mixed liquid in which the high-boiling component is concentrated. Even in the micro gas-liquid counterflow contact device 1A according to Embodiment 2, the first circulation pump 52 and the second circulation pump 62 are sequentially operated as in the micro gas-liquid counterflow contact device 1 described in Embodiment 1, as a matter of course.

### Description of the Reference Numerals and Symbols

- 1: Micro gas-liquid counterflow contact device
- 2: Gas-liquid counterflow contact unit
- 5: First circulation unit
- 6: Second circulation unit
- 21: Liquid introduction port
- 22: Vapor introduction port
- 23: Gas-liquid contact flow path
- 24: Liquid discharge port
- 25: Vapor discharge port
- 26: Liquid introduction path
- 27: Liquid discharge path
- 28: Vapor introduction path
- 29: Vapor discharge path
- 100: Control apparatus

## Claims

1. A micro gas-liquid counterflow contact device, comprising:
a gas-liquid counterflow contact unit including a liquid introduction port through which a mixed liquid containing at least two types of components different in boiling point is introduced, a vapor introduction port through which a mixed-liquid-derived vapor is introduced, a gas-liquid contact flow path configured to bring the mixed liquid introduced from the liquid introduction port and the mixed-liquid-derived vapor introduced from the vapor introduction port into contact with each other in counterflows, a liquid discharge port from which the mixed liquid flowing through the gas-liquid contact flow path is discharged, and a vapor discharge port from which the mixed-liquid-derived vapor flowing through the gas-liquid contact flow path is discharged;
a first circulation unit configured to circulate, to the liquid introduction port, a condensate obtained by condensing the mixed-liquid-derived vapor discharged from the vapor discharge port; and
a second circulation unit configured to circulate, to the vapor introduction port, the vapor obtained by evaporating the mixed liquid discharged from the liquid discharge port.

2. The micro gas-liquid counterflow contact device according to claim 1, wherein
in the gas-liquid counterflow contact unit, the gas-liquid contact flow path is configured as a flow path extending in one direction,
one end side of the gas-liquid contact flow path is disposed on an upper side in a vertical direction, and the liquid introduction port and the vapor discharge port are disposed on the one end side, and
another end side of the gas-liquid contact flow path is disposed on a lower side in the vertical direction, and the liquid discharge port and the vapor introduction port are disposed on the other end side.

3. The micro gas-liquid counterflow contact device according to claim 1 or 2, wherein, in the gas-liquid counterflow contact unit, the mixed liquid introduced from the liquid introduction port flows down in a liquid flowing region formed along a flow path wall surface forming the gas-liquid contact flow path, and the mixed-liquid-derived vapor supplied from the vapor introduction port flows in a direction opposite to the direction of the mixed liquid, along a vapor flowing region formed on a cross-section center side of the gas-liquid contact flow path.

4. The micro gas-liquid counterflow contact device according to claim 3, wherein the gas-liquid counterflow contact unit includes a plurality of the liquid introduction ports and a plurality of the liquid discharge ports.

5. The micro gas-liquid counterflow contact device according to claim 4, wherein
the flow path wall surface of the gas-liquid counterflow contact unit includes a first surface and a second surface different from the first surface,
the plurality of liquid introduction ports include first and second liquid introduction ports disposed on one end side of the gas-liquid contact flow path,
the plurality of liquid discharge ports include first and second liquid discharge ports disposed on another end side of the gas-liquid contact flow path,
the mixed liquid introduced from the first liquid introduction port flows down on the first surface of the flow path wall surface, and then, is discharged from the first liquid discharge port, and
the mixed liquid introduced from the second liquid introduction port flows down on the second surface of the flow path wall surface, and then, is discharged from the second liquid discharge port.

6. The micro gas-liquid counterflow contact device according to claim 2, wherein the gas-liquid counterflow contact unit further includes an intermediate introduction port introducing the mixed liquid at an intermediate position of the gas-liquid contact flow path, separately from the liquid introduction port disposed on the one end side of the gas-liquid contact flow path.

7. The micro gas-liquid counterflow contact device according to claim 1 or 2, wherein the first circulation unit includes a first storage tank configured to store the condensate obtained by condensing the mixed-liquid-derived vapor discharged from the vapor discharge port.

8. The micro gas-liquid counterflow contact device according to claim 1 or 2, wherein the second circulation unit includes a second storage tank configured to store the mixed liquid discharged from the liquid discharge port of the gas-liquid counterflow contact unit.

9. The micro gas-liquid counterflow contact device according to claim 1 or 2, wherein the second circulation unit further includes an evaporation unit including a micro flow path through which the mixed liquid discharged from the liquid discharge port of the gas-liquid counterflow contact unit flows, and an evaporation heater configured to evaporate the mixed liquid flowing through the micro flow path.

10. The micro gas-liquid counterflow contact device according to claim 1 or 2, wherein the gas-liquid counterflow contact unit further includes a temperature adjustment mechanism configured to form a predetermined temperature gradient in which a temperature is gradually reduced from another end side toward one end side of the gas-liquid contact flow path.

11. The micro gas-liquid counterflow contact device according to claim 2, wherein, in the gas-liquid counterflow contact unit, a liquid introduction path connecting the one end side of the gas-liquid contact flow path and the liquid introduction port, and a liquid discharge path connecting the other end side of the gas-liquid contact flow path and the liquid discharge port are formed as micro flow paths.

12. The micro gas-liquid counterflow contact device according to claim 3, wherein a liquid film thickness of the mixed liquid flowing down along the flow path wall surface is in an order of micrometers.
